Europäisches Patentamt

European Patent Office

Office européen des brevets

(11) Publication number: **0 115 143**
**A2**

(12) # EUROPEAN PATENT APPLICATION

(21) Application number: **83307627.6**

(22) Date of filing: **15.12.83**

(51) Int. Cl.³: **H 01 L 27/02**
**H 01 L 23/52**

(30) Priority: **28.12.82 JP 227612/82**

(43) Date of publication of application:
**08.08.84 Bulletin 84/32**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Emori, Shinji**
**1345-51, Tajima**
**Urawa-shi Saitama 336(JP)**

(74) Representative: **Sunderland, James Harry et al,**
**HASELTINE LAKE & CO Hazlitt House 28 Southampton**
**Buildings Chancery Lane**
**London WC2A 1AT(GB)**

(54) **Integrated circuit with electrostatic breakdown prevention circuits.**

(57) An integrated circuit having a high resistance to electrostatic breakdown before mounting and a high operation speed after mounting. At least one series-connected fuse element (F1) and electrostatic breakdown prevention device (D1) is provided between an external terminal (P) and a power source line (Vcc) and/or ground line (VEE) in the integrated circuit. After the integrated circuit is mounted to a printed circuit board, a voltage is applied to melt the fuse element, separating the electrostatic breakdown prevention device from the integrated circuit.

*Fig. 1*

# INTEGRATED CIRCUIT WITH ELECTROSTATIC BREAKDOWN PREVENTION CIRCUITS

The present invention relates to an integrated circuit (IC) provided with electrostatic breakdown prevention circuits, particularly to an IC with electrostatic breakdown prevention circuits which can be disconnected from other circuits of the IC after the IC is mounted.

Recently, IC's have featured increasingly high-speed operation and high integration. Along with this, finer construction IC patterns and shallow junctions have come into increased use. Use of fine patterns and shallow junctions increases the speed of IC operation, however, reduces the resistance to electrostatic breakdown. Measures to prevent electrostatic breakdown therefore have become necessary.

Up until now, the basic measure taken to prevent electrostatic breakdown was to provide circuits for absorbing the electrostatic energy rather than to increase the resistance to electrostatic breakdown per se, as the latter is difficult without significantly reducing the IC operation speed. Various kinds of elements and circuits have been proposed for this purpose. Even the provision of electrostatic breakdown prevention means for a high-speed IC, however, will reduce the operation speed somewhat. Generally, the larger the dimensions of the IC pattern forming an electrostatic breakdown prevention element, the greater the protection/effect of the element. On the other hand, the larger the pattern dimensions of an element, the less appropriate the element is for high-speed IC operation.

An embodiment / of the present invention can provide an IC with electrostatic breakdown prevention circuits which can be separated from the other circuits of the IC after mounting of the IC, thus eliminating the adverse effect of the same on the IC operation speed.

According to the present invention, there is provided an IC comprising an external terminal, a series connection circuit of a fuse element and an electrostatic breakdown prevention means between the external terminal and a power source line or a ground line. The fuse element is connected between the external terminal and the electrostatic breakdown prevention means, and an inner circuit is connected to the external terminal.

Reference is made, by way of example, to the accompanying drawings in which:-

Figure 1 is a diagram of an electrostatic breakdown prevention circuit of an IC according to an embodiment of the present invention;

Fig. 2 is a plan view of a pattern in the case where the circuit of Fig. 1 is formed on a semiconductor substrate; and

Fig. 3 is a partial sectional view of the pattern of Fig. 2 along the line A-A.

Electrostatic breakdown of an IC primarily occurs during the packaging, testing, transporting, or mounting to a printed circuit board or the like. Electrostatic breakdown of an IC rarely occurs after mounting to a printed circuit board. This is because the resistance to electrostatic breakdown is increased by the increased stray capacity arising from connection to external circuits and decreased impedance arising from the parallel connection of other parts. Also, of course, after mounting, the opportunities for direct contact of IC's by workers or tools decrease. This is another reason for the decrease in electrostatic breakdown. Therefore, after mounting an IC, the electrostatic largely
breakdown prevention elements are/superfluous. The
present invention was conceived of based on this fact.

In the present invention, the electrostatic breakdown prevention circuits enable high resistance to
electrostatic breakdown until IC mounting. After IC
mounting, the electrostatic breakdown prevention circuits
are separated from the other circuits of the IC, thus
not obstructing high IC operation speed.

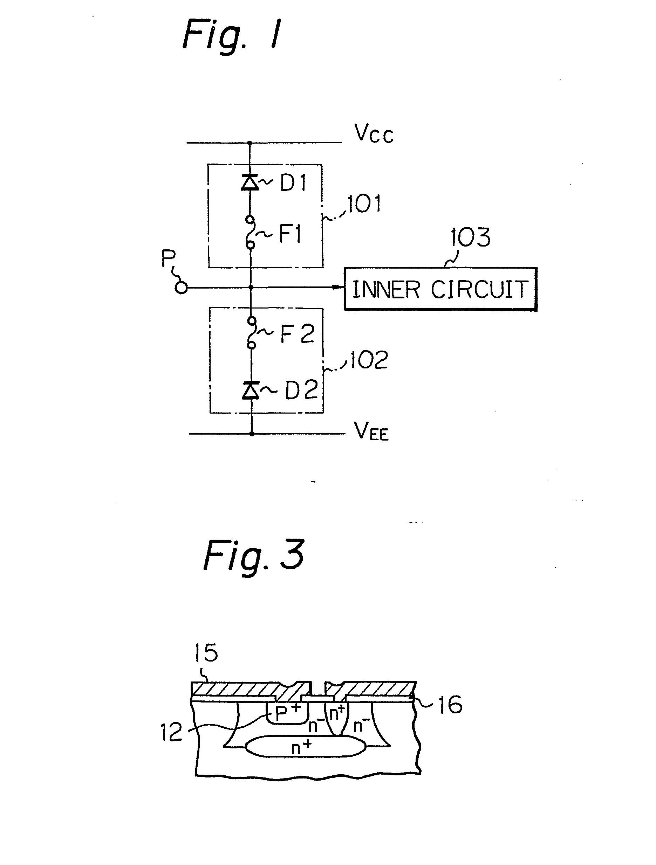

Figure 1 is a diagram of an electrostatic breakdown
prevention circuit of an IC according to an embodiment
of the present invention. The electrostatic breakdown
prevention circuit (101, 102) of Fig. 1 is connected to
a conductor connecting an input or output terminal P and
an inner circuit of the IC.

The circuit of Fig. 1 comprises a diode D1 and a
fuse F1 series-connected between a power source $V_{CC}$
line having a voltage $V_{CC}$ and the conductor connecting
terminal P to the inner circuit 103, and a fuse F2 and a
diode D2 series-connected between the conductor connecting terminal P to the inner circuit 103 and a ground $V_{EE}$
line having a voltage $V_{EE}$. Both fuses are connected
on the side of the diode closest to the conductor connecting terminal
P to the inner circuit 103.

If the voltage $V_P$ of the input or output terminal P
of the IC is between $V_{EE}$ and $V_{CC}$, both the diodes
D1 and D2 receive a backward bias voltage. Since the
signal voltages at the input or output terminals of the
IC have voltage values between $V_{CC}$ and $V_{EE}$, the
addition of the fuses and diodes has no effect on the
static characteristics of the IC or on the basic
function thereof. When the terminal P receives an
electrostatic surge voltage, however, the diodes D1 and
D2 absorb electrostatic energy and act as protective
elements to protect the inner circuit of the IC.

Since the diodes D1 and D2 also work as elements
having an electrostatic capacity, they decrease the
operation speed of the IC. The decrease of the operation speed is very serious for a high-speed IC.

To prevent a decrease of the operation speed, after the IC is mounted to a printed circuit board, the fuses F1 and F2 are melted by applying a voltage slightly higher than the forward voltage drop of the diodes D1 or D2 between the terminal P and the power source $V_{CC}$ line or ground $V_{EE}$ line. This disconnects the diodes D1 and D2 from the terminal P. This technique enables one to use, as an electrostatic breakdown prevention element, an element with a high protection ability which would otherwise significantly reduce the operation speed of the IC.

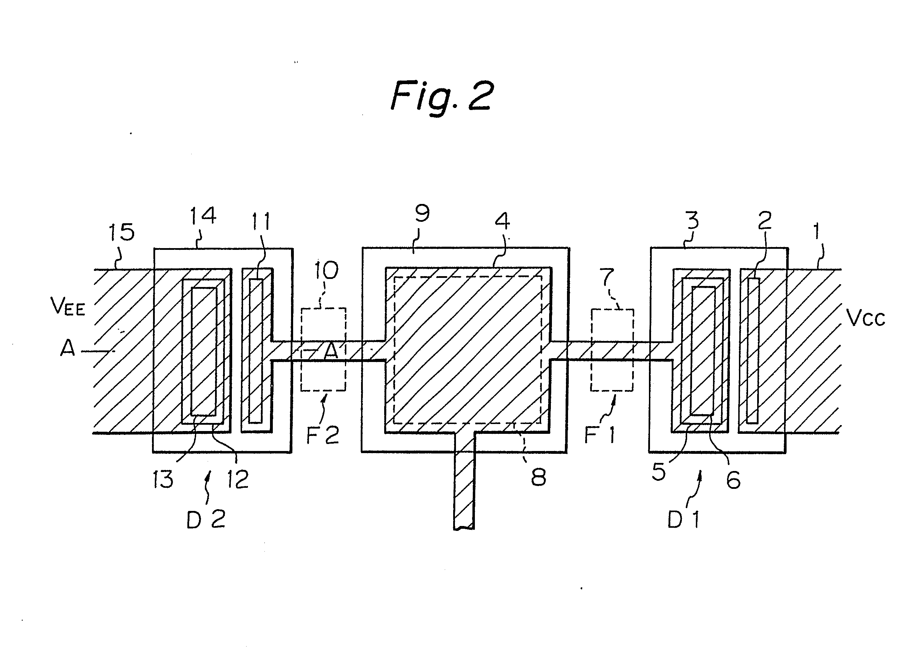

Figure 2 is a plan view of a pattern in the case where the electrostatic breakdown prevention circuit of Fig. 1 is formed on the semiconductor substrate of the IC using PN junction diodes. In Fig. 2, reference numeral 1 is the conductor pattern of the power source $V_{CC}$, 2 is a cathode contact hole of the diode D1 connected to the power source $V_{CC}$ line, 3 is an N-type area isolated from the substrate for the diode D1, 4 is a metallized pattern of a bonding pad to connect the terminal P through a lead wire, 5 is a $P^+$ diffusion area for the diode D1, 6 is an anode contact hole of the diode D1, 7 is a cover layer aperture for the fuse F1, 8 is a cover layer aperture for the bonding pad, 9 is a pad area isolated from the substrate for the bonding pad, 10 is a cover layer aperture for the fuse F2, 11 is a cathode contact hole of the diode D2, 12 is a $P^+$ diffusion area for the diode D2, 13 is an anode contact hole of the diode D2, 14 is an N-type area isolated from the substrate for the diode D2, and 15 is the conductor pattern of the ground $V_{EE}$ line. In Fig. 2, the fuses F1 and F2 are narrow patterns made of the same material as the wiring of the integrated circuit. The material is metal, polycrystalline silicon, or the like. Although PN junction diodes are shown as the diodes, Schottky diodes may be used instead.

Figure 3 is a partial sectional view of the pattern of Fig. 2 along the line A-A. In the Figure, the hatched portion shows the conductor pattern. Reference numeral 16 shows an insulator layer. Reference symbol $n^+$ shows N-type semiconductor containing a larger amount of impurities, and $n^-$ an N-type semiconductor containing a smaller amount of impurities. The P-type semiconductor of the $P^+$ diffusion area 12 is used for the anode of the diode, and the N-type semiconductor is used for the cathode of the diode. While not shown in the Figure, generally the surface of the pattern is covered with a cover layer. The cover layer is taken off at bonding portions of the lead wires. On the fuses F1 and F2, the cover layer is also taken off, as shown by blocks of broken lines in Fig. 2, creating the cover layer apertures 7 and 10. The cover layer aperture on the fuse not only ensures that when the fuse melts, the fuse is easily broken by partial evaporation, but also prevents cracking of the cover layer. This therefore prevents deterioration of the reliability of the IC after the fuse is cut.

Although diodes are used as the electrostatic breakdown prevention means in this embodiment, thyristors, transistors, or combination transistors, resistors, and the like can also be used. The fuses should withstand electrostatic energy small in quantity but high instantaneously in voltage and should be melted by heat due to electrical energy low in voltage but applied over a comparatively long time. So long as the above-mentioned characteristics are satisfied, the fuses may be made of any material in any form appropriate for the IC production process.

An IC with electrostatic breakdown prevention circuits according to this embodiment may not be tested for dynamic characteristics, e.g., switching characteristics, before mounting, because the diodes D1 and D2 are connected to the input or output terminals. However, the dynamic characteristics of IC's belonging to the same production lot can be estimated by melting the fuses and then testing the characteristics of a sample chip from the identical lot.

It will be understood that, while two series-connected fuses and diodes (101 and 102 in Fig. 1) are provided for the same terminal in the above embodiment, it is possible to provide a single fuse and diode (for example 102 in Fig. 1), connected in series between the terminal and either a ground $V_{EE}$ line or a power source $V_{CC}$ line.

Of course, protection circuits in accordance with the present invention may be applied to a number of terminals of the same IC.

## CLAIMS

1. An integrated circuit comprising: an external terminal; at least one series connection circuit of a fuse element and an electrostatic breakdown prevention means between said external terminal and a power source line and/or a ground line, said fuse element being connected between said external terminal and said electrostatic breakdown prevention means; and an inner circuit connected to said external terminal.

2. An integrated circuit as set forth in claim 1, wherein said electrostatic breakdown prevention means is a PN junction diode.

3. An integrated circuit as set forth in claim 1, wherein said electrostatic breakdown prevention means is a Schottky diode.

4. An integrated circuit as set forth in claim 1, 2, or 3, wherein the material of said fuse element is the same as that of wiring of said inner circuit.

5. An integrated circuit as set forth in any preceding claim, wherein the material of said fuse element is polycrystalline silicon.

6. An integrated circuit as set forth in any preceding claim, wherein said integrated circuit comprises a cover layer to protect the surface of the chip of said integrated circuit, and said cover layer has apertures on said fuse element.

# Fig. 1

Vcc

D1

~101

F1

P

INNER CIRCUIT

103

F2

~102

D2

VEE

# Fig. 3

15

16

P+   n-   n+   n-

12

n+

# Fig. 2